(19) Europäisches Patentamt
European Patent Office
Office européen des brevets

(11) **EP 2 471 181 B1**

(12) **EUROPÄISCHE PATENTSCHRIFT**

(45) Veröffentlichungstag und Bekanntmachung des Hinweises auf die Patenterteilung:
**18.03.2020  Patentblatt 2020/12**

(21) Anmeldenummer: **10745162.7**

(22) Anmeldetag: **11.08.2010**

(51) Int Cl.:
***H03M 3/02*** *(2006.01)*

(86) Internationale Anmeldenummer:
**PCT/EP2010/004903**

(87) Internationale Veröffentlichungsnummer:
**WO 2011/023294 (03.03.2011 Gazette 2011/09)**

(54) **VERFAHREN ZUR VERARBEITUNG EINES EINEN ANALOG BESTIMMTEN WERT FÜR AUSGANGSSTROM EINES UMRICHTERS DARSTELLENDEN MESSWERTSIGNALS UND VORRICHTUNG ZUR DURCHFÜHRUNG DES VERFAHRENS**

METHOD FOR PROCESSING A MEASUREMENT SIGNAL REPRESENTING A VALUE DETERMINED IN AN ANALOGUE WAY FOR THE OUTPUT CURRENT OF A CONVERTER AND DEVICE FOR CARRYING OUT THE METHOD

PROCEDE DE TRAITEMENT D'UN SIGNAL DE MESURE REPRÉSENTANT UNE VALEUR DÉTERMINÉE DE MANIÈRE ANALOGIQUE POUR LA COURANT DE SORTIE D'UN CONVERTISSEUR ET DISPOSITIF DE MISE EN OEUVRE

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **26.08.2009  DE 102009038595
26.07.2010  DE 102010032296**

(43) Veröffentlichungstag der Anmeldung:
**04.07.2012  Patentblatt 2012/27**

(73) Patentinhaber: SEW-EURODRIVE GmbH & Co. KG
**76646 Bruchsal (DE)**

(72) Erfinder:
• **KNAPP, Thomas**
**76461 Muggensturm (DE)**
• **KOLLAR, Hans Jürgen**
**76646 Bruchsal (DE)**
• **NEUMAYER, Ulrich**
**76694 Forst (DE)**
• **HAMMEL, Wolfgang**
**76646 Bruchsal (DE)**

(56) Entgegenhaltungen:
**DE-B4-102005 005 024     US-B1- 6 311 201**

• **Texas Instruments Incorporated: "Motor Control Current Shunt1-Bit, 10MHz, 2nd-Order, Delta-Sigma Modulator", , 1. Juli 2004 (2004-07-01), XP002615723, Gefunden im Internet: URL:http://focus.ti.com/lit/ds/symlink/ads 1202.pdf [gefunden am 2010-12-17]**
• **Texas Instruments: "Motor Control Current Shunt 1-Bit, 10MHz, 2nd-Order, Delta-Sigma Modulator to +150°C Operating Free-Air Temperature Range to +150°C Lead Temperature 1.6mm (1/16") from Case for 10s", , 1 December 2002 (2002-12-01), XP055379806, Retrieved from the Internet: URL:http://pdf1.alldatasheet.com/datasheet -pdf/view/82381/BURR-BROWN/ADS1202.html [retrieved on 2017-06-08]**

**Beschreibung**

Die Erfindung betrifft ein Verfahren zur Verarbeitung eines einen analog bestimmten Wert für Ausgangsstrom eines Umrichters darstellenden Messwertsignals und eine Vorrichtung zur Durchführung des Verfahrens.

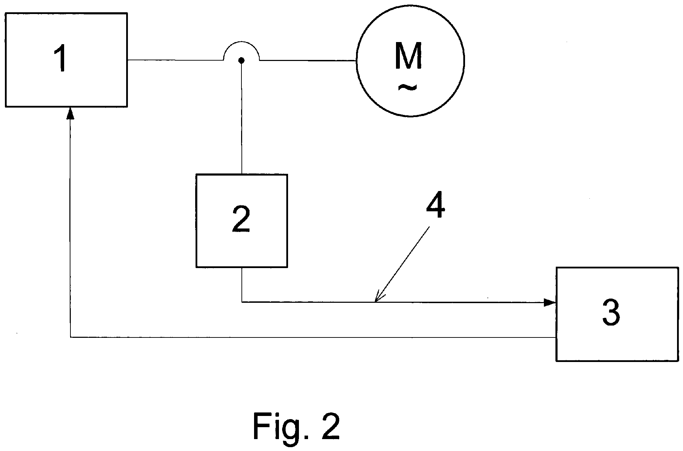

Aus der DE 10 2005 005 024 B4 ist ein Verfahren bekannt, bei dem die von einem als Winkelsensor eingesetzten Resolver erzeugten analogen Trägerspannungs-Signalwerte, deren Verlauf im Wesentlichen sinusförmig ist und deren Amplitude dem Sinuswert beziehungsweise dem Kosinuswert des zu erfassenden Winkelwertes entsprechen, in einen digitalen Datenstrom gewandelt werden. Zu dieser Analog-Digital-Wandlung wird ein Delta-Sigma-Modulator eingesetzt, dem ein $Sinc^3$-Filter nachgeschaltet ist, das als Tiefpassfilter wirkt. Denn die drei integrierend wirkenden Akkumulatoren der dortigen Figur 5 werden mit einer schnelleren Taktfrequenz $F_S$ als die drei mit der langsameren Taktfrequenz $F_D$ betriebenen Differentiatoren betrieben. Am Filter tritt ausgangsseitig ein Mehrbit-Datenstrom aus, der gemäß dortiger Figur 2 einem Dezimierungsfilter OSR2 zugeführt wird, das im Wesentlichen einer Summation, also Mittelwertbildung entspricht. An dessen Ausgang steht somit der Messwert in digitaler Form bereit.

Eine Synchronisierung des Mehrbit-Datenstroms auf sonstige Signalverläufe hin ist nur schwer oder gar nicht möglich. Die Messdauer bzw. Beginn und Ende des Messintervalls ist nur mit langen Zeitdauer $T_D$ einstellbar, da das Signal am Ausgang des dritten Integrierers mit $f_D$ unterabgetastet wird. Somit stehen ab dieser Stelle in der Signalkette sämtliche Signale nur mit der groben zeitlichen Quantisierung $T_D$ zur Verfügung. Die Festlegung des Beginns bzw. Endes oder der Messdauer über die das Dezimierungsfilter OSR2 misst kann daher nur in ganzen Vielfachen von $T_D$ erfolgen. In industriellen Anwendungen besteht jedoch häufig die Notwendigkeit, unterlagerte Regelkreise auf überlagerte Regelkreise zu synchronisieren. Diese unterschiedlichen Regelkreise können auch räumlich getrennt realisiert werden, wobei dann die zeitliche Referenzierung über ein Feldbus-System übertragen wird. Somit besteht die Aufgabe, den unterlagerten Regelkreis auf einen von außen vorgegebenen Takt zu synchronisieren. Hierzu wird üblicherweise die Periodendauer des Abtastintervalls der unterlagerten Regelkreise geringfügig verändert, um diese Synchronisation zu erreichen. Um die Synchronisierung mit hoher Qualität durchführen zu können, ist es notwendig, die Periodendauer des unterlagerten Regelkreises in möglichst kleinen Schritten verändern zu können. Eine zeitlich grobe Quantisierung der kleinsten möglichen Periodendauer-Modifikation schränkt die erreichbare Qualität der Synchronisierungsregelung somit ein. Da innerhalb einer Regelschleife auch die MesswertErfassung synchronisiert betrieben wird, führt eine grobe Quantisierung der Messzeitpunkte bzw. der Messdauer ebenfalls zu einer Einschränkung bei der Synchronisations-Regelung. Die zugrundeliegende Aufgabe der vorliegenden Erfindung besteht also darin, ein Messverfahren anzugeben, bei dem die Festlegung des Beginns und Endes des Messintervalls bzw. der Messdauer mit einer hohen zeitlichen Auflösung möglich ist. Bei dem erfindungsgemäßen Erfahren beträgt diese zeitliche Quantisierung $T_S$, welche bei der DE 10 2005 005 024 B4 $T_D$ beträgt. Um eine ausreichende Filterwirkung des Tiefpassfilters zu erzielen ist jedoch $T_D$ wesentlich größer als $T_S$ zu wählen, wodurch sich die genannten Einschränkungen im beschriebenen Stand der Technik ergeben.

Aus der EP 0 320 517 B1 ist ein digitales Dezimationsfilter bekannt, bei dem ein letzter Differenzierer k Verzögerungsglieder aufweist, welche um die Periodendauer des Ausgangsdatentaktes, also Dezimationstakt dt, verzögern. Somit sind also nur ganzzahlige Vielfache des Dezimationstakts dt als dortige Verzögerung realisierbar. Allerdings wird der letzte der Integrierer in der Figur 1 der EP 0 320 517 B1 gemäß dortigem Anspruch 1 mit Rücksetzeinrichtung ausgestattet, der somit wie ein Differenzierer wirkt (EP 0 320 517 B1, Anspruch 1, Zeile 56).

Aus der Veröffentlichung, Texas Instruments Incorporated,: "Motor Control Current Shunt 1-Bit, 10MHz, 2nd-Order, Delta-Sigma-Modulator", 1. Juli 2004, ist ein Verfahren zur Verarbeitung eines einen analog bestimmten Stromwert darstellenden Messwertsignals bekannt.

Aus der DE 10 2005 005 024 B4 ist eine Resolver-Anordnung bekannt, die einen Sigma-Delta-Modulator und ein Digitalfilter aufweist.

Aus der Figur 8 der US 6 311 201 B1 ist ein Dezimationsfilter bekannt, bei welchem ungefähr ein zeitdiskretes Differential zweiter Ordnung bestimmt wird.

Der Erfindung liegt daher die Aufgabe zugrunde, die Analog-Digital-Wandelung bei einer Messwerterfassung weiterzubilden.

Erfindungsgemäß wird die Aufgabe bei dem Verfahren nach den in Anspruch 1 und bei der Vorrichtung nach Anspruch 10 angegebenen Merkmalen gelöst.

Wichtige Merkmale der Erfindung bei dem Verfahren sind, dass es zur Verarbeitung eines einen analog bestimmten Wert für Ausgangsstrom eines Umrichters darstellenden Messwertsignals dient,
wobei die von einem Sensor, insbesondere umfassend einen Shunt-Widerstand, erfassten Messwertsignale einem jeweiligen Verarbeitungskanal zugeführt werden, der zumindest einen Delta-Sigma-Modulator aufweist.

Von Vorteil ist dabei, dass der Messwert analog erfasst wird und dieser analoge Wert dem Delta-Sigma-Modulator zuführbar ist und somit in eine digitale Darstellung wandelbar ist. Dabei ist besonders vorteilhaft, dass der aus dem Modulator austretende Datenstrom ein Ein-Bit-Datenstrom ist und somit einfach weiterleitbar ist zu einer Auswerteeinheit, wie beispielsweise einer Signalelektronik mit digitalem Filter. Außerdem ist ein Jitter-Problem vermeidbar.

Bei einer vorteilhaften Ausgestaltung wird der Ausgangsdatenstrom des Delta-Sigma-Modulators einem digitalen Filter zugeführt, wobei der Ausgangsdatenstrom gemäß einem Manchester-Code-Verfahren übertragen wird zum digitalen Filter, insbesondere wobei das Filter räumlich getrennt ist vom Delta-Sigma-Modulator. Von Vorteil ist dabei, dass zur Datenübertragung nur eine Eindrahtverbindung erforderlich ist.

Bei einer vorteilhaften Ausgestaltung wird ein jeweiliges Messwertsignal einem Delta-Sigma-Modulator zugeführt, der ausgangsseitig einen Bitstrom, insbesondere einen Ein-Bit-Datenstrom, zur Verfügung stellt. Von Vorteil ist dabei, dass dieser besonders einfach übertragbar ist. Insbesondere ist nur eine einzige galvanische Trennvorrichtung, wie induktiver Übertrager, notwendig.

Bei einer vorteilhaften Ausgestaltung werden digitale Daten, insbesondere ein Einbit-Ausgangsdatenstrom des Delta-Sigma-Modulators, übertragen als einfaches Ein-Bit-Binärsignal, insbesondere ohne zusätzliche Übertragung eines Taktsignals, und/oder im Manchester-Code. Von Vorteil ist dabei, dass ein einziger differentieller serieller Datenkanal zur Übertragung der Daten notwendig ist. Empfangsseitig ist dann eine Herausfilterung des Taktsignals ermöglicht und damit auch eine Rekonstruktion des Einbit-Ausgangs-Datenstroms des Modulators.

Bei einer vorteilhaften Ausgestaltung wird der Ausgangsdatenstrom des Delta-Sigma-Modulators zumindest einem digitalen Filter zugeführt, insbesondere einem vom Delta-Sigma-Modulator räumlich getrennt angeordneten. Von Vorteil ist dabei, dass eine galvanisch getrennte Übertragung des Datenstroms vom Modulator zum Filter mit einfachen Mitteln ausführbar ist.

Bei einer vorteilhaften Ausgestaltung wird das Messwertsignal einem Delta-Sigma-Modulator zugeführt, der ausgangsseitig einen Bitstrom, insbesondere einen Ein-Bit-Datenstrom, zur Verfügung stellt,

wobei der Bitstrom einem ersten digitalen Filter zugeführt wird, das den Bitstrom in einen Strom von digitalen Zwischenwörtern, also einen Mehrbit-Datenstrom, verwandelt,

wobei das erste digitale Filter eine Anzahl n seriell angeordneter Akkumulatoren, insbesondere Integratoren, aufweist, wobei n ganzzahlig und gleich oder größer als 1 insbesondere gleich oder größer als 2, ist,

wobei der Bitstrom mit einer Taktfrequenz $f_S$, also mit einer Taktperiode $T_S = 1/f_S$, getaktet ist und somit der Strom von digitalen Zwischenwörtern mit einer Taktfrequenz $f_S$, also der Taktperiode $T_S = 1/f_S$, getaktet und somit aktualisiert wird,

wobei das Ausgangssignal des ersten digitalen Filters einem zweiten digitalen Filter zugeführt wird,

wobei das zweite digitale Filter als Ausgangs-Datenwortstrom die Differenz zwischen einem ersten und einem zweiten Ergebnis-Datenwortstrom aufweist,

wobei der erste und zweite Ergebnis-Datenwortstrom über ein erstes und zweites Zeitintervall aus dem Zwischendatenwortstrom bestimmt werden, wobei das erste und zweite Zeitintervall in einem zeitlichen Abstand T1 angeordnet sind,

wobei der erste Ergebnis-Datenwortstrom als zeitdiskretes Differential (n -1) -ter Ordnung mit Zeitskala $T_D$ aus dem Zwischendatenwortstrom bestimmt wird und wobei der zweite Ergebnis-Datenwortstrom als zeitdiskretes Differential (n -1) -ter Ordnung mit Zeitskala $T_D$ aus dem Zwischendatenwortstrom bestimmt wird,

wobei der zeitliche Abstand T1 größer als die Zeitskala $T_D$ ist, insbesondere wobei T1 ein ganzzahliges Vielfaches der Taktperiode $T_S$ ist.

Der Signaltakt $T_U$ am Ausgang des zweiten digitalen Filters ist je nach Anwendungs-und Ausführungsbeispiel des Verfahrens verschieden wählbar. Beispielsweise ist als Signaltakt $T_U$ hierbei T1, $T_D$ oder auch $T_S$ oder jedes andere ganzzahlige Vielfache von $T_S$ verwendbar. Vorteilhaft ist hierbei, dass $T_U$ als Vielfaches von TS gewählt werden kann und daher mit hoher zeitlicher Auflösung einstellbar ist. Beispielsweise ist die Erfindung bei einer Ausführungsform anwendbar, in der das erfindungsgemäße Verfahren zur Erfassung des Ausgangsstroms "i" eines Umrichters , der pulsweitenmoduliert betrieben wird, verwendet wird. Die Messdauer T1 soll sich hierbei beispielsweise über eine halbe PWM-Periodendauer erstrecken. Damit kann T1 mit der hohen zeitlichen Auflösung von $T_S$ entsprechend der gewünschten Messdauer sehr genau eingestellt werden. Des weiteren soll in jeder PWM-Periode eine Messung erfolgen, somit wird $T_U$ unabhängig von T1 entsprechend der PWM-Periodendauer $T_{PWM}$ festgelegt. Dies kann ebenfalls mit der hohen zeitlichen Auflösung von $T_S$ geschehen. Auch wenn z.B. $T_{PWM}$ kein ganzzahliges Vielfaches von $T_S$ ist, bleibt die zeitliche Abweichung hiervon bei der Festlegung von $T_U$ durch Verwendung des erfindungsgemäßen Verfahrens sehr gering.

Von Vorteil ist dabei, dass eine verbesserte Analog-Digital-Wandlung ausführbar ist, bei der nun ein digitales Filter einsetzbar ist, das einerseits eine Tiefpassfunktion aufweist und andererseits den Datenstrom derart zur Verfügung stellt, dass die digitale Information bezüglich des Signalspannungswertes am Eingang des Delta-Sigma-Modulators mit sehr hoher Genauigkeit zur Verfügung steht. Besonders vorteilhaft ist dabei, dass der Serienanordnung von Akkumulatoren keine Differentiatoren mit nachfolgender Mittelwertbildung folgen sondern nur einige wenige Zwischendatenwörter in jeweils geeignetem zeitlichen Abstand verknüpft werden mittels einfacher Operationen, wie Subtraktion und Addition bzw. Multiplikation mit Faktor 2 oder dergleichen. Somit ist mit geringem Aufwand eine hochgenaue Analog-Digital-Wandlung ausführbar. Außerdem ist auch bei einer Realisierung in Hardware ohne besonderen Aufwand eine Veränderung der Zeitabstände $T_D$ ausführbar.

Weiterer Vorteil der Erfindung ist, dass keine Rücksetzeinrichtungen bei den Akkumulatoren verwendet werden müssen und somit unverfälschte Ergebnisse erreichbar sind.

Wichtige Merkmale bei dem Verfahren sind, dass es zur Verarbeitung eines analog bestimmten Messwertsignals vorgesehen ist,

wobei das Messwertsignal einem Delta-Sigma-Modulator zugeführt wird, der ausgangsseitig einen Bitstrom, insbesondere einen Ein-Bit-Datenstrom, zur Verfügung stellt,

insbesondere dessen Mittelwert oder ein gleitender Mittelwert dem Messwertsignal entspricht,

wobei der Bitstrom einem ersten digitalen Filter zugeführt wird, das den Bitstrom in einen Strom von digitalen Zwischenwörtern, also einen Mehrbit-Datenstrom, verwandelt,

wobei das erste digitale Filter eine Anzahl n seriell angeordneter Akkumulatoren, insbesondere Integratoren, aufweist, wobei n ganzzahlig und gleich oder größer als 1, insbesondere gleich oder größer als 2, ist,

wobei der Bitstrom mit einer Taktfrequenz $f_S$, also mit einer Taktperiode $T_S = 1/f_S$, getaktet ist und somit der Strom von digitalen Zwischenwörtern mit Taktfrequenz $f_S$, also Taktperiode $T_S = 1/f_S$, getaktet und somit aktualisiert wird,

wobei das Ausgangssignal des ersten digitalen Filters einem zweiten digitalen Filter zugeführt wird,

wobei das zweite digitale Filter als Ausgangs-Datenwortstrom die Differenz zwischen einem ersten und einem zweiten Ergebnis-Datenwortstrom aufweist,

wobei der erste und zweite Ergebnis-Datenwortstrom über ein erstes und zweites Zeitintervall aus dem Zwischendatenwortstrom bestimmt werden, wobei das erste und das zweite Zeitintervall in einem zeitlichen Abstand T1 angeordnet sind,

wobei der erste Ergebnis-Datenwortstrom aus dem Zweifachen des zum ersten Zeitpunkt gehörigen Zwischendatenworts bestimmt wird, wobei das im zeitlichen Abstand $T_D$ vor dem ersten Zeitpunkt und das im zeitlichen Abstand $T_D$ nach dem ersten Zeitpunkt angeordnete Zwischendatenwort subtrahiert wird,

wobei der zweite Ergebnis-Datenwortstrom aus dem Zweifachen des zum zweiten Zeitpunkt gehörigen Zwischendatenworts bestimmt wird, wobei das im zeitlichen Abstand $T_D$ vor dem zweiten Zeitpunkt und das im zeitlichen Abstand $T_D$ nach dem zweiten Zeitpunkt angeordnete Zwischendatenwort subtrahiert wird.

Von Vorteil ist dabei, dass zur Erreichung eines qualitativ hochwertigen digitalen Signals schon drei Akkumulatoren mit nachgeschaltetem Differential zweiter Ordnung ausreicht.

Bei der Erfindung ist weiter von Vorteil, dass die Berechnungsschritte für die Bestimmung des Ausgangs-Datenwortstrom des zweiten digitalen Filters, also die Differenzbildung zwischen einem ersten und einem zweiten Ergebnis-Datenwortstrom, überlappend ausführbar sind. Somit ist also durch paralleles zeitlich überlappendes Berechnen, also Bilden von solchen Differenzbildungen, die ausgangsseitige Datenrate weiter erhöhbar.

Bei einer vorteilhaften Ausgestaltung ist T1 größer als das oder gleich dem Zweifache(n) von $T_D$. Von Vorteil ist dabei, dass eine Tiefpassfilterung erreichbar ist.

Bei einer vorteilhaften Ausgestaltung ist die Taktperiodendauer $T_D$ ein ganzzahliges Vielfaches von $T_S$. Von Vorteil ist dabei, dass eine Hardware-Realisierung einfach ausführbar ist.

Bei einer vorteilhaften Ausgestaltung besteht das erste digitale Filter aus drei direkt hintereinander angeordneten Integrierern oder Akkumulatoren. Von Vorteil ist dabei, dass eine einfache digitale Tiefpassfilterung herstellbar ist.

Bei einer vorteilhaften Ausgestaltung entspricht der gleitende Mittelwert des Bitstroms dem Messwertsignal. Somit ist der Messwert in hoher Genauigkeit darstellbar, wenn ein großes zeitliches Intervall für den gleitenden Mittelwert zugrunde gelegt wird.

Bei einer vorteilhaften Ausgestaltung wird das im Delta-Sigma-Modulator verwendete Taktsignal an den Takteingang des ersten digitalen Filters angelegt. Von Vorteil ist dabei, dass eine einfache Realisierung ausführbar ist.

Wichtige Merkmale bei dem Verfahren zur Bestimmung eines Ausgangsstromes eines Umrichters sind, dass die dem Ausgangsstrom entsprechenden von einem Sensor erfassten Messsignale einem jeweiligen Verarbeitungskanal zugeführt werden, innerhalb dessen ein obenbeschriebenes Verfahren durchgeführt wird. Somit ist vorteiligerweise auch bei Umrichtern eine verbesserte Stromerfassung ausführbar.

Wichtige Merkmale bei der Vorrichtung zur Durchführung eines vorgenannten Verfahrens sind, dass der Sensor zusammen mit dem Delta-Sigma-Modulator an der Leistungselektronik angeordnet ist, insbesondere in einem gemeinsamen Gehäuse mit der Leistungselektronik, und der digitale Filter an der Signalelektronik, insbesondere in einem gemeinsamen Gehäuse zusammen mit Signalelektronik. Von Vorteil ist dabei, dass

Bei einer vorteilhaften Ausgestaltung ist das Filter räumlich getrennt angeordnet vom Delta-Sigma-Modulator. Von Vorteil ist dabei, dass

Bei einer vorteilhaften Ausgestaltung sind Delta-Sigma-Modulator und Filter galvanisch getrennt angeordnet, insbesondere wobei eine induktive Übertragung der Signale oder eine Übertragung mittels Lichtwellenleiter ausgeführt ist. Von Vorteil ist dabei, dass

Weitere Vorteile ergeben sich aus den Unteransprüchen.

Die Erfindung wird nun anhand von Abbildungen näher erläutert:

Figur 1 verdeutlicht einen wesentlichen Schritt des erfindungsgemäßen Verfahrens.

Figur 2 zeigt eine herstellbare erfindungsgemäße Anordnung.

Figur 3 zeigt beispielhaft eine Ausführungsform, in der das erfindungsgemäße Verfahren zur Erfassung des Ausgangsstroms "i" eines Umrichters, der pulsweitenmoduliert betrieben wird, verwendet wird.

Dabei wird ein Drehstrommotor M aus einem Umrichter gespeist, wobei der Umrichter mittels seiner Leistungselektronik 1 eine Drehspannung zur Verfügung stellt, so dass die Drehzahl des Motors regelbar ist.

Die Leistungselektronik 1 ist dabei mit einer Endstufe ausgeführt, die drei Halbbrücken von Halbleiterschaltern umfasst, wobei die Schalter pulsweitenmodulierte Ansteuersignale von einer Signalelektronik 3 erhalten oder es werden entsprechende Informationen von der Signalelektronik 3 an eine von der Leistungselektronik 1 umfasste Treiberstufe geliefert, die dann entsprechende pulsweitenmodulierte Signale erzeugt und den Schaltern zuführt.

Die Signalelektronik ist in einem von dem Bereich der Leistungselektronik räumlich abgesetzten Bereich angeordnet. Beispielsweise ist die Leistungselektronik in einem ersten Gehäuse und die Signalelektronik in einem zweiten Gehäuse angeordnet, wobei erstes und zweites Gehäuse an unterschiedlichen Raumbereichen angeordnet sind.

Im Bereich der Leistungselektronik, vorzugsweise im Gehäuse der Leistungselektronik oder mit dem Gehäuse der Leistungselektronik direkt verbunden sind auch Mittel zur Erfassung des Motorstroms angeordnet. Bei dreiphasiger Ausführung des Drehstroms ist hierbei die Erfassung von zwei Phasenströmen des Drehstrommotors ausreichend. Vorzugsweise umfassen die Mittel zumindest einen Shunt-Widerstand. Dieser ist entweder in einer der Halbbrücken der Endstufe des Umrichters angeordnet oder in der Zuleitung aus welcher die drei Halbbrücken versorgt sind. Im letztgenannten Fall ist abhängig vom Zeitpunkt der einer jeweiligen Halbbrücke zugeordnete Strom erfassbar, da bei umrichtergespeisten Drehstrommotoren jeweils zeitabhängig nur einer der Schalter einer jeweiligen Halbbrücke frei geschaltet ist.

Die Mittel 2 zur Erfassung des Motorstroms umfassen zumindest auch einen Delta-Sigma-Modulator. Somit wird jeder an einer Motorphase erfasster Messwert einem jeweiligen Verarbeitungskanal, umfassend einen Delta-Sigma-Modulator, zuführbar. Da der Delta-Sigma-Modulator ausgangsseitig einen Bitstrom liefert, also einen Einbit-Datenstrom, ist der erfasste von analoger in digitale Darstellung gewandelte Wert einfach und ohne großen Aufwand weiterleitbar an eine räumlich entfernt angeordnete Signalelektronik 3. Diese verwendet die erfassten Ströme zur Bestimmung der zu stellenden umrichterausgangsseitigen Spannungswerte beziehungsweise das zugehörige Pulsweitenmodulationsverhältnis.

Die Übertragung des digitalen Einbit-Datenstrom an die Signalelektronik ist besonders einfach in galvanisch getrennter Weise ermöglicht, also beispielsweise über Lichtwellenleiter oder Transformator. Dabei wird die Übertragung unter Verwendung eines Manchester-Code-Datenübertragungsverfahren ausgeführt. Hierbei wird das eigentliche Ausgangssignal des Delta-Sigma-Modulators mit einem höher frequente Taktsig-nal verknüpft, beispielsweise XOR, also Exklusiv-ODER, verknüpft, und dieses verknüpfte Signal übertragen. Das höher frequente Taktsignal weist beispielsweise die halbe Periodendauer auf wie das Sampling-Takt-Signal des Delta-Sigma-Modulators. Die empfangsseitige Decodierung ist einfach und ohne besonderen Aufwand ausführbar. Auf diese Weise ist das Signal über große räumliche Distanzen problemlos übertragbar, insbesondere störsicher. Dabei ist ein leitungsgebundener differentieller serieller Datenkanal einsetzbar, der eine galvanische Trennung umfasst. Alternativ ist auch eine Funkübertragung oder eine Lichtwellenleiterübertragung anwendbar. Für kürzere Distanzen genügt auch eine nichtdifferentielle Datenübertragung.

Ein besonders wichtiger Vorteil der Erfindung ist also hierbei, dass der jeweilige Einbit-Datenstrom auch über lange Strecken ungestört übertragbar ist, da er digital ausgeführt ist.

In der Signalelektronik 3 wird das empfangene und wieder in den Einbit-Datenstrom decodierte, übertragene Signal einem digitalen Filter zugeführt, wobei das Filter von der Signalelektronik umfasst ist. Das Filter weist dabei drei seriell hintereinander geschaltete Integratoren auf, wobei das Ausgangssignal dieser Reihenschaltung einem speziellen Datenverarbeitungsverfahren unterzogen wird.

Das Filter ist ebenfalls vorzugsweise digital ausgeführt und benötigt zwischen den einzelnen Komponenten des Filters Mehrbit-Datenströme, die vorzugsweise mittels paralleler Mehrbit-Datenbusse ausgeführt sind. Eine Übertragung solcher Mehrbit-Datenströme über große Strecken hinweg wäre aufwendig und ist bei der Erfindung nicht notwendig. Außerdem sind die Komponenten des Filters mittels eines Rechners, wie Mikrocontroller oder dergleichen, ausführbar. Dieser Rechner ist beispielsweise auch verwendbar für die Berechnungsschritte des im Umrichter wirksamen Regelverfahrens, also beispielsweise für die Berechnungsschritte einer feldorientierten Regelung des Elektromotors. Somit ist ein ansonsten notwendiger zusätzlicher Rechner einsparbar.

Auf diese Weise ist das rechentechnische anspruchsvolle Filter in der Signalelektronik angeordnet, insbesondere wobei also Komponenten der Signalelektronik auch als Komponenten des Filters wirksam sind.

Der Einbit-Datenstrom jedes Verarbeitungskanals weist als zeitlichen Mittelwert die Information über den Messwert des zugeführten Signals auf.

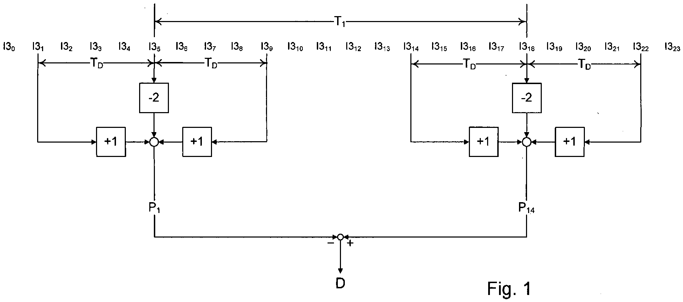

In der Figur 1 ist für einen jeweiligen Verarbeitungskanal ein Teil eines erfindungsgemäßen, dem Delta-Sigma-Modulator nachgeschalteten Filters gezeigt.

Wie auch bei der DE 10 2005 005 024 B4 werden drei mit einer Taktfrequenz $f_S$, also Taktperiode $T_S$ = 1/ $f_S$, betriebene, vom Filter auch umfasste Integratoren, die auch als Akkumulatoren oder Integrier-Glieder bezeichenbar sind und nicht in der Figur 1 gezeigt sind, seriell hintereinander angeordnet, so dass an dieser seriellen Anordnung ein Zwischendatenwortstrom ausgegeben wird. Im Unterschied zur DE 10 2005 005 024 B4, bei der der Zwischendatenwortstrom den drei nachfolgend wiederum seriell angeordneten Differentiatoren zugeführt wird, die allerdings mit der viel langsameren Taktfrequenz $f_D$, also Taktperiode $T_D = 1/ f_D$ , betrieben werden, wird bei der Erfindung ein spezielles Datenverarbeitungsverfahren ausgeführt.

Diese spezielle erfindungsgemäße Datenverarbeitung ist in Figur 1 dargestellt.

Dabei ist wichtig, dass der Zwischendatenwortstrom im Takt der Taktperiode $T_S$, also im Sampling-Takt des Delta-Sigma-Modulators, aktualisiert wird.

Aus diesem Zwischendatenstrom wird ein zeitdiskretes Differential zwei-ter Ordnung bestimmt, indem ein erstes Zwischendatenwort zu einem ersten Zeitpunkt zu einem im zeitlichen Abstand 2 x $T_D$ entfernten Zwischendatenwort addiert und von der so gebildeten Summe der doppelte Wert des zeitlich zwischen diesen beiden Zwischendatenwörtern, mittig liegenden Zwischendatenwortes subtrahiert. Somit ist ein erster Ergebniswert (**P1**) gebildet.

Um einen zweiten Ergebniswert zu bilden, wird zu einem vom genannten ersten Zwischendatenwort im zeitlichen Abstand $T_1$ liegenden Zeitintervall dieselbe Operation ausgeführt. Also wird wiederum zu einem dortigen Zwischendatenwort ein im zeitlichen Abstand 2 x $T_D$ entfernten Zwischendatenwort addiert und von der so gebildeten Summe der doppelte Wert des zwischen diesen beiden Zwischendatenwörtern mittig liegenden Zwischendatenwortes subtrahiert, wobei das mittig liegende Zwischendatenwort den zeitlichen Abstand $T_1$ zu dem zur Berechnung des ersten Ergebniswertes herangezogenen, mittig liegenden Zwischendatenwortes aufweist. Somit ist ein zweiter Ergebniswert (**P14**) gebildet.

Die Differenz D der beiden Ergebniswerte wird ausgangsseitig zur Verfügung gestellt und stellt den gefilterten Messwert in digitaler Form dar, wobei eine hohe Genauigkeit erreichbar ist.

Im Gegensatz zur DE 10 2005 005 024 B4 sind keine Differentiatoren und auch kein ausgangsseitiges Dezimierungsfilter OSR2 notwendig, da erfindungsgemäß das ausgangsseitige Ergebnis direkt mittels der Differenz aus erstem und zweitem Ergebnis bestimmt wird.

Besonderer Vorteil der Erfindung ist auch, dass T1 ein beliebiges ganzzahliges Vielfaches von $T_S$ ist, wobei keine weitere Festlegung getroffen werden muss. Selbstverständlich ist dabei vorteiligerweise T1 größer als das Zweifache von $T_D$, also T1 > $T_D$. Da 1 / $T_S$ beispielsweise mehrere MHz beträgt, also beispielsweise mehr als 10 MHz, beträgt, ist T1 in feinen Schritten veränderbar.

Somit ist während der Betriebszeit T1 mit hoher zeitlicher Auflösung veränderbar und es sind somit Synchronisierungen auf andere getaktete Signalströme ohne besonderen Aufwand ausführbar. Wenn beispielsweise die erfindungsgemäße Messwertverarbeitung der Signale eines Resolvers einer Steuerelektronik eines Umrichters zugeführt werden, ist es daher in einfacher Weise ermöglicht, eine Synchronisierung auf einen von einem mit dem Umrichter verbundenen Feldbus vorgegebenen Takt auszuführen. Hierzu muss also nur der Wert von T1 verändert werden, was mit der hohen zeitlichen Auflösung von $T_S$ ausführbar ist.

Bei weiteren erfindungsgemäßen Ausführungsbeispielen wird statt dem zweiten zeitdiskreten Differential ein Differential zeitdiskretes Differential erster, zweiter, dritter oder höherer Ordnung eingesetzt, wenn die Anzahl der Integratoren, also Akkumulatoren, entsprechend verändert ist. Wenn also n Integratoren vorgesehen sind, wird zur Bildung des ersten und zweiten Ergebniswertes jeweils ein n-Tupel von regelmäßig voneinander mit Zeitabstand $T_D$ beabstandeten Zwischendatenwörtern $f_k$ verwendet, wobei k von 0 bis n-1 läuft. Dabei wird das Differential gebildet, indem die Summe

$$\sum_{k=0}^{n-1}(-1)^k \binom{n-1}{k} f_k$$

gebildet wird, wobei der Summationsindex k von 0 bis n-1 läuft.

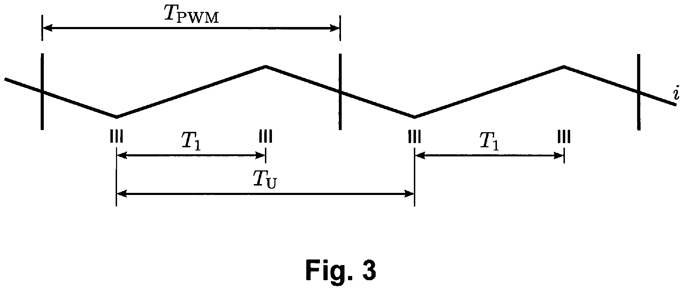

In Figur 3 ist beispielhaft eine Ausführungsform dargestellt, in der das erfindungsgemäße Verfahren zur Erfassung des Ausgangsstroms "i" eines Umrichters, der pulsweitenmoduliert betrieben wird, verwendet wird. Die Messdauer T1 soll sich hierbei beispielsweise über eine halbe PWM-Periodendauer erstrecken. Damit kann T1 mit der hohen zeitlichen Auflösung von $T_S$ entsprechend der gewünschten Messdauer sehr genau eingestellt werden.

In der Figur 3 sind die Zeitpunkte, welche zur Bestimmung der Differentiale zweiter Ordnung verwendet werden jeweils durch ein Dreierpaket von kleinen Strichen dargestellt. Jedes Dreierpaket hat eine zeitliche Länge von 2 x $T_D$. Da $T_D$ aber sehr viel größer als $T_S$ ist, ist eine Darstellung des zeitlichen Abstandes $T_S$ in der Figur 3 nicht mehr möglich.

Des weiteren soll in jeder PWM-Periode eine Messung erfolgen. Somit wird $T_U$ unabhängig von T1 entsprechend der PWM-Periodendauer $T_{PWM}$ festgelegt. Dies kann ebenfalls mit der hohen zeitlichen Auflösung von $T_S$ geschehen. Auch wenn beispielsweise $T_{PWM}$ kein ganzzahliges Vielfaches von $T_S$ ist, bleibt die zeitliche Abweichung hiervon bei der Festlegung von $T_U$ durch Verwendung des erfindungsgemäßen Verfahrens sehr gering.

**Bezugszeichenliste**

| $T_S$ | = 1/ $f_S$ Taktperiode |
|---|---|
| $T_D$ | = 1/ $f_D$ Taktperiode |
| T1 | Zeitabstand |
| M | Drehstrommotor |
| D | Differenz |

I3$_0$　　I3$_{23}$ **Zwischendatenstrom**
P1　　erster Ergebniswert
P14　　zweiter Ergebniswert

1　　Leistungselektronik mit Endstufe
2　　Stromerfassung
3　　Signalelektronik zur Erzeugung der PWM-Ansteuersignale für Schalter der Endstufe
4　　Ein-bit -Datenleitung

**Patentansprüche**

1. Verfahren zur Verarbeitung eines einen analog bestimmten Wert für Ausgangsstrom eines Umrichters darstellenden Messwertsignals,
   wobei die von einem Sensor, insbesondere umfassend einen Shunt-Widerstand, erfassten Messwertsignale einem jeweiligen Verarbeitungskanal zugeführt werden, der zumindest einen Delta-Sigma-Modulator aufweist,
   wobei das Messwertsignal dem Delta-Sigma-Modulator zugeführt wird, der ausgangsseitig einen Bitstrom, nämlich einen Ein-Bit-Datenstrom, zur Verfügung stellt,
   wobei der Bitstrom einem ersten digitalen Filter zugeführt wird, das den Bitstrom in einen Strom von digitalen Zwischenwörtern, also einen Mehrbit-Datenstrom, verwandelt,
   wobei das erste digitale Filter eine Anzahl n seriell angeordneter Akkumulatoren, insbesondere Integratoren, aufweist, wobei n drei ist,
   wobei der Bitstrom mit einer Taktfrequenz $f_S$, also mit einer Taktperiode $T_S = 1/f_S$, getaktet ist wobei der Strom von digitalen Zwischenwörtern mit einer Taktfrequenz $f_S$, also der Taktperiode $T_S = 1/f_S$, getaktet und somit aktualisiert wird,
   wobei das Ausgangssignal des ersten digitalen Filters einem zweiten digitalen Filter zugeführt wird, wobei
   das zweite digitale Filter als Ausgangs-Datenwortstrom die Differenz (D) zwischen einem ersten und einem zweiten Ergebnis-Datenwortstrom aufweist,
   wobei der erste und zweite Ergebnis-Datenwortstrom über ein erstes und zweites Zeitintervall aus dem Zwischendatenwortstrom bestimmt werden,
   wobei das erste und zweite Zeitintervall in einem zeitlichen Abstand T1 angeordnet sind,
   wobei der erste Ergebnis-Datenwortstrom als zeitdiskretes Differential (n -1) -ter Ordnung mit Zeitskala $T_D$ aus dem Zwischendatenwortstrom bestimmt wird und
   wobei der zweite Ergebnis-Datenwortstrom als zeitdiskretes Differential (n -1) -ter Ordnung mit Zeitskala $T_D$ aus dem Zwischendatenwortstrom bestimmt wird,
   wobei T1 größer ist als das Zweifache von $T_D$ oder dem Zweifachen von $T_D$ gleicht.

2. Verfahren nach Anspruch 1,
   **dadurch gekennzeichnet, dass**
   der erste Ergebnis-Datenwortstrom aus dem Zweifachen des zum ersten Zeitpunkt gehörigen Zwischendatenworts bestimmt wird, wobei das im zeitlichen Abstand $T_D$ vor dem ersten Zeitpunkt und das im zeitlichen Abstand $T_D$ nach dem ersten Zeitpunkt angeordnete Zwischendatenwort subtrahiert wird,
   wobei der zweite Ergebnis-Datenwortstrom aus dem Zweifachen des zum zweiten Zeitpunkt gehörigen Zwischendatenworts bestimmt wird, wobei das im zeitlichen Abstand $T_D$ vor dem zweiten Zeitpunkt und das im zeitlichen Abstand $T_D$ nach dem zweiten Zeitpunkt angeordnete Zwischendatenwort subtrahiert wird
   wobei T1 größer ist als das Zweifache von $T_D$ oder dem Zweifachen von $T_D$ gleicht.

3. Verfahren nach mindestens einem der vorangegangenen Ansprüche,
   **dadurch gekennzeichnet, dass**
   der Ausgangsdatenstrom des Delta-Sigma-Modulators einem digitalen Filter zugeführt wird, wobei der Ausgangsdatenstrom gemäß einem Manchester-Code-Verfahren übertragen wird zum digitalen Filter, insbesondere wobei das Filter räumlich getrennt ist vom Delta-Sigma-Modulator.

4. Verfahren nach mindestens einem der vorangegangenen Ansprüche,
   **dadurch gekennzeichnet, dass**
   ein jeweiliges Messwertsignal einem Delta-Sigma-Modulator zugeführt wird, der ausgangsseitig einen Bitstrom, insbesondere einen Ein-Bit-Datenstrom, zur Verfügung stellt, und/oder dass
   digitale Daten, insbesondere ein Einbit-Ausgangsdatenstrom des Delta-Sigma-Modulators, übertragen werden als einfaches Ein-Bit-Binärsignal, insbesondere ohne zusätzliche Übertragung eines Taktsignals, und/oder im Manchester-Code.

5. Verfahren nach mindestens einem der vorangegangenen Ansprüche,
   **dadurch gekennzeichnet, dass**
   der Ausgangsdatenstrom des Delta-Sigma-Modulators zumindest einem digitalen Filter zugeführt wird, insbesondere einem vom Delta-Sigma-Modulator räumlich getrennt angeordneten.

6. Verfahren nach einem der Ansprüche 2 bis 5,
   **dadurch gekennzeichnet, dass**
   die Taktperiodendauer $T_D$ ein ganzzahliges Vielfaches von $T_S$ ist.

7. Verfahren nach mindestens einem der vorangegangenen Ansprüche,
   **dadurch gekennzeichnet, dass**
   das erste digitale Filter aus drei direkt hintereinander angeordneten Integrierern oder Akkumulatoren besteht.

**8.** Verfahren nach mindestens einem der vorangegangenen Ansprüche,
**dadurch gekennzeichnet, dass**
ein gleitender Mittelwert des Bitstroms dem Messwertsignal entspricht.

**9.** Verfahren nach mindestens einem der vorangegangenen Ansprüche,
**dadurch gekennzeichnet, dass**
das im Delta-Sigma-Modulator verwendete Taktsignal filterseitig separiert wird und an den Takteingang des ersten digitalen Filters angelegt wird.

**10.** Vorrichtung zur Durchführung eines Verfahrens nach mindestens einem der vorangegangenen Ansprüche,
wobei die Vorrichtung einen Delta-Sigma-Modulator und einen digitalen Filter aufweist,
wobei der digitale Filter einen ersten digitalen Filter und einen zweiten digitalen Filter aufweist,
wobei der erste digitale Filter eine Anzahl n seriell angeordneter Akkumulatoren, insbesondere Integratoren , aufweist,
wobei n drei ist,
wobei die Vorrichtung konfiguriert ist, um ein von einem Sensor erfasstes Messwertsignal zu verarbeiten, wobei der Sensor zusammen mit dem Delta-Sigma-Modulator an einen Leistungselektronik (1) angeordnet ist, insbesondere in einem gemeinsamen Gehäuse mit der Leistungselektronik, und der digitale Filter an der Signalelektronik (3), insbesondere in einem gemeinsamen Gehäuse zusammen mit Signalelektronik (3).

**11.** Vorrichtung nach Anspruch 10, **dadurch gekennzeichnet, dass**
das Filter räumlich getrennt angeordnet ist vom Delta-Sigma-Modulator.

**12.** Vorrichtung nach Anspruch 10 oder 11, **dadurch gekennzeichnet, dass**
Delta-Sigma-Modulator und Filter galvanisch getrennt angeordnet sind,
wobei eine induktive Übertragung der Signale oder eine Übertragung mittels Lichtwellenleiter ausgeführt ist.

**Claims**

**1.** Method for processing a measured-value signal representing a value determined in an analogue manner for the output current of a converter,
wherein the measured-value signals detected by a sensor, which in particular comprises a shunt resistor, are supplied to a respective processing channel having at least one delta-sigma modulator,
wherein the measured-value signal is supplied to the delta-sigma modulator, which provides a bit stream, specifically a single-bit data stream, at its output,
wherein the bit stream is supplied to a first digital filter, which converts the bit stream into a stream of digital intermediate words, i.e. a multi-bit data stream,
wherein the first digital filter has a number n of accumulators, in particular integrators, arranged in series, wherein n is 3,
wherein the bit stream is clocked at a clock frequency $f_S$, i.e. with a clock period $T_S = 1/f_S$,
wherein the stream of digital intermediate words is clocked and thus updated at a clock frequency fs, i. e. with the clock period $T_S = 1/f_S$,
wherein the output signal of the first digital filter is supplied to a second digital filter,
wherein the second digital filter has the difference (D) between a first and a second result data word stream as the output data word stream,
wherein the first and second result data word streams are determined from the intermediate data word stream over a first and second time range, wherein the first and second time ranges are arranged in an interval T1,
wherein the first result data word stream is determined from the intermediate data word stream as a discrete-time differential of the (n-1)th order having the time scale $T_D$ and
wherein the second result data word stream is determined from the intermediate data word stream as a discrete-time differential of the (n-1)th order having the time scale $T_D$,
wherein T1 is greater than double $T_D$ or equal to double $T_D$.

**2.** Method according to claim 1,
**characterised in that**
the first result data word stream is determined from double the intermediate data word associated with the first time, the intermediate data word arranged before the first time in the interval $T_D$ and after the first time in the interval $T_D$ being subtracted,
the second result data word stream being determined from double the intermediate data word associated with the second time, the intermediate data word arranged before the second time in the interval $T_D$ and after the second time in the interval $T_D$ being subtracted, T1 being greater than double $T_D$ or equal to double $T_D$.

**3.** Method according to at least one of the preceding claims,
**characterised in that**
the output data stream of the delta-sigma modulator is supplied to a digital filter, the output data stream being transmitted to the digital filter in accordance with a Manchester code procedure, the filter in particular being spatially separate from the delta-sigma modulator.

4. Method according to at least one of the preceding claims,
   **characterised in that**
   each measured-value signal is supplied to a delta-sigma modulator, which provides a bit stream, in particular a single-bit data stream, at its output, and/or **in that**
   digital data, in particular a single-bit output data stream of the delta-sigma modulator, are transmitted as a simple single-bit binary signal, in particular without any additional transmission of a clock signal, and/or in the Manchester code.

5. Method according to at least one of the preceding claims,
   **characterised in that**
   the output data stream of the delta-sigma modulator is supplied to at least one digital filter, in particular to a filter arranged spatially separately from the delta-sigma modulator.

6. Method according to any of claims 2 to 5,
   **characterised in that**
   the clock period duration $T_D$ is an integer multiple of $T_S$.

7. Method according to at least one of the preceding claims,
   **characterised in that**
   the first digital filter consists of three integrators or accumulators arranged directly one behind the other.

8. Method according to at least one of the preceding claims,
   **characterised in that**
   a moving average of the bit stream corresponds to the measured-value signal.

9. Method according to at least one of the preceding claims,
   **characterised in that**
   the clock signal used in the delta-sigma modulator is separated out at the filter and applied to the clock input of the first digital filter.

10. Device for carrying out a method according to at least one of the preceding claims,
    wherein the device has a delta-sigma modulator and a digital filter,
    wherein the digital filter has a first digital filter and a second digital filter,
    wherein the first digital filter has a number n of accumulators, in particular integrators, arranged in series,
    wherein n is 3,
    wherein the device is configured to process a measured-value signal detected by a sensor,
    wherein the sensor is arranged on a power electronics (1) together with the delta-sigma modulator, in particular in a common housing together with the power electronics, and the digital filter is arranged on the signal electronics (3), in particular in a common housing together with the signal electronics (3).

11. Device according to claim 10,
    **characterised in that**
    the filter is arranged spatially separately from the delta-sigma modulator.

12. Device according to either claim 10 or claim 11,
    **characterised in that**
    the delta-sigma modulator and the filter are arranged in a galvanically isolated manner, the signals being inductively transmitted or transmitted using optical waveguides.

**Revendications**

1. Procédé de traitement d'un signal de valeur de mesure représentant une valeur déterminée de manière analogique du courant de sortie d'un variateur,
   dans lequel les signaux de valeur de mesure détectés par un capteur, en particulier comprenant une résistance shunt, sont amenés à un canal de traitement respectif qui présente au moins un modulateur delta-sigma,
   dans lequel le signal de valeur de mesure est amené au modulateur delta-sigma, qui fournit en sortie un flux de bits, à savoir un flux de données à un bit,
   dans lequel le flux de bits est amené à un premier filtre numérique qui convertit le flux de bits en un flux de mots numériques intermédiaires, c'est-à-dire un flux de données à plusieurs bits,
   dans lequel le premier filtre numérique présente un nombre n d'accumulateurs, en particulier d'intégrateurs, disposés en série,
   dans lequel n est égal à trois,
   dans lequel le flux de bits est cadencé à une fréquence d'horloge $f_S$, c'est-à-dire à une période d'horloge $T_S = 1/f_S$,
   dans lequel le flux de mots numériques intermédiaires est cadencé et donc actualisé à une fréquence d'horloge fs, c'est-à-dire à la période d'horloge $T_S = 1/f_S$,
   dans lequel le signal de sortie du premier filtre numérique est amené à un deuxième filtre numérique,
   dans lequel le deuxième filtre numérique présente en tant que flux de mots de données de sortie la différence (D) entre un premier et un deuxième flux de mots de données de résultat,

dans lequel les premier et deuxième flux de mots de données de résultat sont déterminés à partir du flux de mots de données intermédiaires sur un premier et un deuxième intervalle de temps, les premier et deuxième intervalles de temps étant disposés à une distance temporelle T1,

dans lequel le premier flux de mots de données de résultat est déterminé en tant que dérivée à temps discret d'ordre (n - 1) avec une échelle de temps $T_D$ à partir du flux de mots de données intermédiaires et dans lequel le deuxième flux de mots de données de résultat est déterminé en tant que dérivée à temps discret d'ordre (n - 1) avec une échelle de temps $T_D$ à partir du flux de mots de données intermédiaires, dans lequel T1 est supérieur au double de $T_D$ ou égal au double de $T_D$.

2. Procédé selon la revendication 1,
**caractérisé en ce**
**que** le premier flux de mots de données de résultat est déterminé à partir du double du mot de données intermédiaires associé au premier instant, le mot de données intermédiaires disposé à la distance temporelle $T_D$ avant le premier instant et le mot de données intermédiaires disposé à la distance temporelle $T_D$ après le premier instant étant soustraits,
dans lequel le deuxième flux de mots de données de résultat est déterminé à partir du double du mot de données intermédiaires associé au deuxième instant, le mot de données intermédiaire disposé à la distance temporelle $T_D$ avant le deuxième instant et le mot de données intermédiaires disposé à la distance temporelle $T_D$ après le deuxième instant étant soustraits,
dans lequel T1 est supérieur au double de $T_D$ ou égal au double de $T_D$.

3. Procédé selon au moins l'une des revendications précédentes,
**caractérisé en ce**
**que** le flux de données de sortie du modulateur delta-sigma est amené à un filtre numérique, le flux de données de sortie étant transmis au filtre numérique selon un procédé à code Manchester, en particulier le filtre étant séparé spatialement du modulateur delta-sigma.

4. Procédé selon au moins l'une des revendications précédentes,
**caractérisé en ce**
**qu'**un signal de valeur de mesure respectif est amené à un modulateur delta-sigma qui fournit en sortie un flux de bits, en particulier un flux de données à un bit, et/ou que des données numériques, en particulier un flux de données de sortie à un bit, du modulateur delta-sigma, sont transmises sous la forme d'un signal binaire simple à un bit, en particulier sans transmission supplémentaire d'un signal d'horloge, et/ou en code Manchester.

5. Procédé selon au moins l'une des revendications précédentes,
**caractérisé en ce**
**que** le flux de données de sortie du modulateur delta-sigma est amené à au moins un filtre numérique, en particulier à un filtre séparé spatialement du modulateur delta-sigma.

6. Procédé selon l'une des revendications 2 à 5,
**caractérisé en ce**
**que** la période d'horloge $T_D$ est un multiple entier de $T_S$.

7. Procédé selon au moins l'une des revendications précédentes,
**caractérisé en ce**
**que** le premier filtre numérique est constitué de trois intégrateurs ou accumulateurs disposés directement les uns derrière les autres.

8. Procédé selon au moins l'une des revendications précédentes,
**caractérisé en ce**
**qu'**une valeur moyenne mobile du flux de bits correspond au signal de valeur de mesure.

9. Procédé selon au moins l'une des revendications précédentes,
**caractérisé en ce**
**que** le signal d'horloge utilisé dans le modulateur delta-sigma est séparé du côté filtre et appliqué à l'entrée d'horloge du premier filtre numérique.

10. Dispositif pour mettre en œuvre un procédé selon au moins l'une des revendications précédentes, dans lequel le dispositif comprend un modulateur delta-sigma et un filtre numérique, dans lequel le filtre numérique présente un premier filtre numérique et un deuxième filtre numérique,
dans lequel le premier filtre numérique présente un nombre n d'accumulateurs, en particulier d'intégrateurs, disposés en série,
dans lequel n est égal à trois,
dans lequel le dispositif est configuré pour traiter un signal de valeur de mesure détecté par un capteur,
dans lequel le capteur est disposé avec le modulateur delta-sigma sur une électronique de puissance (1), en particulier dans un boîtier commun avec l'électronique de puissance, et le filtre numérique est disposé sur l'électronique de signal (3), en particulier dans un boîtier commun avec l'électronique de signal (3).

11. Dispositif selon la revendication 10,
**caractérisé en ce**

**que** le filtre est disposé de manière séparée spatialement du modulateur delta-sigma.

**12.** Dispositif selon la revendication 10 ou 11, **caractérisé en ce**
que le modulateur delta-sigma et le filtre sont disposés de manière galvaniquement séparée,
une transmission inductive des signaux ou une transmission au moyen de fibres optiques étant réalisée.

Fig. 1

Fig. 2

**Fig. 3**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005005024 B4

- EP 0320517 B1
- US 6311201 B1

**In der Beschreibung aufgeführte Nicht-Patentliteratur**

- Motor Control Current Shunt 1-Bit, 10MHz, 2nd-Order, Delta-Sigma-Modulator. Texas Instruments Incorporated, 01. Juli 2004